(19) Europäisches Patentamt
European Patent Office
Office européen des brevets

(11) EP 1 146 394 A1

(12) **EUROPEAN PATENT APPLICATION**
published in accordance with Art. 158(3) EPC

(43) Date of publication:
**17.10.2001 Bulletin 2001/42**

(21) Application number: **00937264.0**

(22) Date of filing: **16.06.2000**

(51) Int Cl.[7]: **G03F 7/022**, C08L 101/00, H01L 21/027

(86) International application number:
**PCT/JP00/03925**

(87) International publication number:
**WO 01/02909 (11.01.2001 Gazette 2001/02)**

(84) Designated Contracting States:
**AT BE CH CY DE DK ES FI FR GB GR IE IT LI LU MC NL PT SE**

(30) Priority: **06.07.1999 JP 19157999**

(71) Applicant: **CLARIANT INTERNATIONAL LTD.**
**4132 Muttenz (CH)**

(72) Inventors:
- **KAWATO, Shunji, Clariant (Japan) K.K.**
**Ogasa-gun, Shizuoka 437-1496 (JP)**
- **TAKAHASHI, Shuichi, Clariant (Japan) K.K.**
**Ogasa-gun, Shizuoka 437-1496 (JP)**

(74) Representative: **Hütter, Klaus, Dr. et al**
**Clariant Service GmbH**
**Patente, Marken, Lizenzen**
**Am Unisys-Park 1**
**65843 Sulzbach (DE)**

(54) **PHOTOSENSITIVE RESIN COMPOSITION AND METHOD FOR IMPROVING DRY ETCHING RESISTANCE OF PHOTOSENSITIVE RESIN COMPOSITION**

(57) A radiation sensitive resin composition which is capable of forming excellent patterns and is highly sensitive and excellent in dry-etching resistance, as well as a process on the improvement of dry-etching resistance. The radiation sensitive resin composition comprises an alkali-soluble resin, a radiation sensitive material and a compound with phenolic hydroxyl groups which has a value of 30 or more in parameter (P) shown in formula 1 below.

[Formula 1]

parameter (P) = [(13.0 x number of hydroxyl groups in an additive)/(number of benzene rings in an additive)] + [(14.0 x number of diazo-coupling reaction points in an additive) / (number of benzene rings in an additive)]

wherein the number of diazo-coupling reaction points is the number of unsubstituted carbon atoms at o- and p-positions relative to the positions of hydroxyl groups in the benzene ring in the compound.

EP 1 146 394 A1

## Description

### Technical Field

The present invention relates to a novel radiation sensitive resin composition and a method for improving dry-etching resistance of a radiation sensitive resin composition, more particularly to a novel radiation sensitive resin composition having improved dry-etching resistance and a method for improving dry-etching resistance of a radiation sensitive resin composition, which can be preferably used for production of semiconductors, formation of liquid crystal display faces for LCD panels, and production of circuit substrates such as thermal heads.

### Background Art

In a wide variety of fields including production of semiconductor integrated circuits such as LSI, formation of liquid crystal display faces for LCD panels, and production of circuit substrates such as thermal heads, photolithographic techniques have been used for formation of fine elements and fine processing. In the photolithographic techniques, positive- or negative-working radiation sensitive resin compositions have been used to form resist patterns. As the positive-working resin composition, a composition comprising an alkali-soluble resin and a quinone diazide compound is well-known as a radiation sensitive material. On this composition, there are described a variety of compositions as e.g. "novolak resin/quinone diazide compound" in many literatures such as Japanese Patent Application Publication (JP-B) No. 54-23570 (US Patent No. 3,666,473), JP-B No. 56-30850 (US Patent No. 4,115,128), Japanese Patent Application Laid-Open (JP-A) No. 55-73045 and JP-A No. 61-205933. Such a radiation sensitive resin composition is applied by a known method such as spin coating, roller coating, land coating, cast coating or dip coating onto a silicon substrate, a substrate coated with a metal such as aluminum, molybdenum or chromium, or a substrate coated with a metal oxide such as ITO, to form a thin film thereon, which is then exposed through a mask pattern for circuit etc. with radiation such as UV rays as a light source. After exposure, it is developed to form a resist pattern. Then fine processing of the substrate with dry-etching can be conducted by use of the resist pattern as an etching mask. In the dry-etching process, adequate dry-etching resistance is required to the resist pattern functioning as a mask. On the other hand, the large-sizing of substrates of LCD panels for TFT is advancing. From the viewpoint of throughput (yield per unit time), the radiation sensitive resin composition with higher sensitivity is required for producing the LCD panels. There is a strong demand, therefore, for realizing the radiation sensitive resin having both improved dry-etching resistance and higher sensitivity.

In such demand, improvement of dry-etching resistance is conducted generally by using an alkali-soluble resin having a high molecular weight or by removing components having low-molecular weights in a specific range, such as monomer and dimer components, from an alkali-soluble resin (e.g., JP-A Nos. 60-97347 and 60-189739 and Japanese Patent No. 2590342). However, there arises another problem, that is, a reduction in sensitivity in the former and a reduction in both sensitivity and adhesion in the latter. Accordingly, it has been difficult to improve the dry-etching resistance of the radiation sensitive resin composition while maintaining its sensitivity.

Under these circumstances, the object of the present invention is to provide a radiation sensitive resin composition comprising an alkali-soluble resin and a radiation sensitive material, which is capable of forming excellent patterns and is highly sensitive and excellent in dry-etching resistance as desired in the prior art, as well as a method for improving dry-etching resistance while maintaining the high sensitivity of a radiation sensitive resin composition comprising an alkali-soluble resin and a radiation sensitive material.

### Disclosure of the Invention

As a result of their eager study and examination, the present inventors found that the object described above can be achieved by adding a compound having phenolic hydroxyl groups with a value of 30 or-more in parameter (P) shown in formula 1 below to a radiation sensitive resin composition comprising an alkali-soluble resin and a radiation sensitive material, and the present invention was thereby completed.

[Formula 1]

parameter (P) = [(13.0 x number of hydroxyl groups in an

additive)/(number of benzene rings in an

additive)] + [(14.0 x number of diazo-

coupling reaction points in an additive) /

(number of benzene rings in an additive)]

wherein the number of diazo-coupling reaction points is the number of unsubstituted carbon atoms at o- and p-positions relative to the positions of hydroxyl groups in the benzene ring in the compound.

Hereinafter, the present invention will be explained in more detail.

The alkali-soluble resin in the radiation sensitive resin composition of the present invention may be any resin used as an alkali-soluble resin component in the conventional radiation sensitive resin compositions. Among these, a novolak phenol type resin obtained by polycondensation between at least one of phenols and aldehydes such as formalin is mentioned as a preferable example.

The phenols used preferably for producing this alkali-soluble novolak resin include e.g. cresols such as o-cresol, p-cresol and m-creosol; xylenols such as 3,5-xylenol, 2,5-xylenol, 2,3-xylenol and 3,4-xylenol; trimethylphenols such as 2,3,4-trimethylphenol, 2,3,5-trimethylphenol, 2,4,5-trimethylphenol and 3,4,5-trimethylphenol; t-butylphenols such as 2-t-butylphenol, 3-t-butylphenol and 4-t-butylphenol; methoxyphenols such as 2-methoxyphenol, 3-methoxyphenol, 4-methoxyphenol, 2,3-dimethoxyphenol, 2,5-dimethoxyphenol, and 3,5-dimethoxyphenol; ethylphenols such as 2-ethylphenol, 3-ethylphenol, 4-ethylphenol, 2,3-diethylphenol, 3,5-diethylphenol, 2,3,5-triethylphenol and 3,4,5-triethylphenol; chlorophenols such as o-chlorophenol, m-chlorophenol, p-chlorophenol and 2,3-dichlorophenol; resorcinols such as resorcinol, 2-methylresorcinol, 4-methylresorcinol and 5-methylresorcinol; catechols such as 5-methylcatechol; pyrogallols such as 5-methylpyrogallol; bisphenols such as bisphenols A, B, C, D, E and F; methylol cresols such as 2,6-dimethylol-p-cresol; and naphthols such as $\alpha$-naphthol and $\beta$-naphthol. These can be used alone or as a mixture thereof.

The aldehydes used preferably for producing the alkali-soluble novolak resin include salicylaldehyde, paraformaldehyde, acetaldehyde, benzaldehyde, hydroxy benzaldehyde and chloroacetaldehyde as well as formalin. These can be used alone or as a mixture thereof.

The alkali-soluble resin used in the present invention suffices for the need if it has enough resistance to arbitrary dry-etching conditions. It may also be a resin from which low-molecular-weight components have been removed as necessary by fractionation. The method of removing low-molecular-weight components from the novolak resin by fractionation includes e.g. liquid-liquid fractionation using two solvents having different dissolution abilities mutually to the components, a method of removing low-molecular-weight components by centrifugation, and thin-film distillation.

The radiation sensitive material in the present invention is a material which can be chemically altered upon irradiation with a light of wavelength overlapping with the absorption zone of the radiation sensitive material, thus changing the solubility of the radiation sensitive resin composition in water or organic solvent. The radiation sensitive material, 0 which can be used together with the alkali-soluble resin, includes e.g. a compound containing a quinone diazide group. This compound containing a quinone diazide group, which can be used in the present invention, may be any known radiation sensitive material used conventionally in quinone diazide-novolak type resist.

The compound containing a quinone diazide group is preferably one obtained by allowing naphthoquinonediazide sulfonyl chloride such as 1,2-naphthoquinonediazide-5-sulfonyl chloride and 1,2-naphthoquinonediazide-4-sulfonyl chloride, or benzoquinonediazidesulfonyl chloride to react with a low-molecular or high-molecular compound having a functional group capable of condensation reaction with these acid chlorides. The functional group which can be condensed with an acid chloride includes a hydroxyl group, an amino group etc. Among these, a hydroxyl group is particularly preferable. The compound containing a hydroxyl group which can be condensed with an acid chloride includes e.g. hydroquinone; resorcinol; hydroxybenzophenones such as 2,4-dihydroxybenzophenone, 2,3, 4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone and 2,2',3,4,6'-pentahydroxybenzophenone; hydroxyphenylalkanes such as bis(2,4-dihydroxyphenyl)methane, bis(2,3,4-trihydroxyphenyl)methane and bis(2,4-dihydroxyphenyl)propane; and hydroxytriphenylmethanes such as 4,4',3",4"-tetrahydroxy-3,5,3',5'-tetramethyltriphenyl-methane and 4,4',2",3",4"-pentahydroxy-3,5,3',5'-tetramethyl triphenyl methane. These can be used alone or in combination of two or more thereof. The amount of the radiation sensitive material containing a quinone diazide group is usually 5 to 50 parts by weight, preferably 10 to 40 parts by weight relative to 100 parts by weight of the alkali-soluble resin. In the radiation sensitive resin composition according to the present invention, a radiation sensitive resin consisting of a reaction product between the alkali-soluble resin and the quinone diazide compound may also be used.

On the other hand, in the radiation sensitive resin composition of the present invention, a compound having phenolic hydroxyl groups with a value of 30 or more in parameter (P) shown in formula 1 above is used as an additive. Although the present invention is not bound by theory, the reason for the combination in each item used in formula 1 is considered as follows:

That is, the additive is used to attain higher sensitivity thereby permitting use of a higher-molecular-weight alkali-soluble resin in the present invention, and because of the high-molecular-weighted effect of the alkali-soluble resin and the high-molecular-weighted effect by diazo coupling, dry-etching resistance can be improved without reduction in sensitivity. The rate of dissolution of the composition exposed is increased with an increasing number of hydroxyl groups in the additive. Therefore higher sensitization is attained by addition of the additive with larger number of hydroxyl groups. However if it is added in a larger amount to the composition, dry-etching resistance is lowered due to an increase of the amount of low-molecular-weight component. Further, it is known that the diazo coupling of the radiation sensitive material with the alkali-soluble resin and the additive in an unexposed part of the positive-working radiation sensitive resin composition occurs upon contacting with a developing solution, to form a slightly soluble layer on the surface. Therefore, the molecular weight of the remaining radiation sensitive resin layer after development is increased by the coupling reaction, and the surface of the composition has improved dry-etching resistance.

As described above, the compound having phenolic hydroxyl groups used as the additive in the present invention has the function of conferring higher sensitivity on the radiation sensitive resin composition comprising an alkali-soluble resin and a radiation sensitive material. Such an additive includes compounds having a value of 30 or more in parameter (P) shown in formula 1, which are represented by formulae (I) to (V):

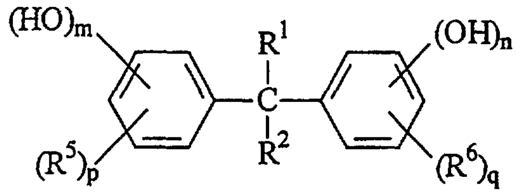

( I )

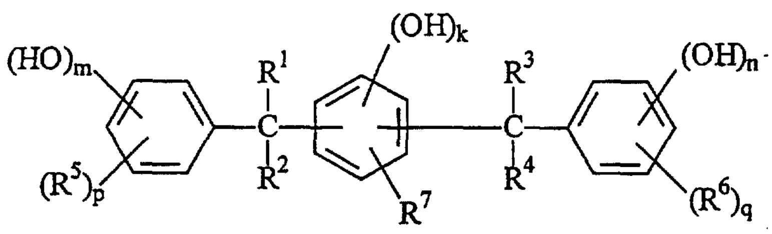

( II )

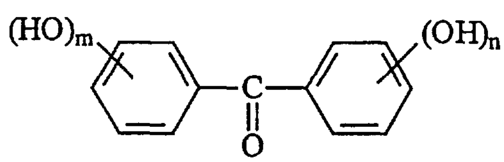

( III )

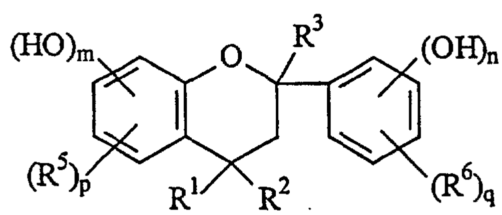

( IV )

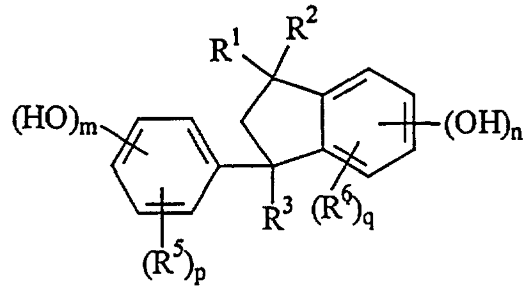

( V )

wherein $R^1$, $R^2$, $R^3$ adn $R^4$ are independent to each other, may be the same and represent a hydrogen atom, a $C_1$ to $C_{10}$ alkyl group, a hydroxyphenyl group, a polyvalent hydroxyphenyl group, a hydroxyphenethyl group, a hydroxybenzyl group, a poly(hydroxyphenyl) methyl group and a bis(hydroxybenzyl) hydroxyphenyl group; $R^5$ and $R^6$ are independent to each other, may be the same, and represent a hydrogen atom, a $C_1$ to $C_{10}$ alkyl group, an acetyl group, a hydroxybenzyl group, a hydroxybenzoyl group and a hydroxymesityl group; and $R^7$ represents a hydrogen atom, a $C_1$ to $C_{10}$ alkyl group, a $C_3$ to $C_{10}$ cycloalkyl group and a hydroxybenzyl group. The benzene ring in substituents described above may be substituted with other substituents such as a $C_1$ to $C_{10}$ alkyl group and a $C_1$ to $C_{10}$ alkoxyl group. In the formulae, k, m, n, p and q represent 0 or an integer of 1 to 5.

The compound having phenolic hydroxyl groups used as the additive in the present invention is specifically as follows: The compound having a parameter (P) value of 30 to less than 40 includes e.g. 4,4',4'',4'''-(1,4-phenylenedimethylidyne) tetrakisphenol, 4,4'-[(3-hydroxyphenyl)methylene]bis[2-methylethylphenol], 2,2'-[(3-hydroxyphenyl) methylene]bis[3,5,6-trimethylphenol], 2,2'-[(2-hydroxy-3-methoxylphenyl)methylene]bis[3,5-dimethylphenol], 2,2'-[(4-hydroxy-3-methoxyphenyl)methylene]bis[3,5-dimethylphenol], 4-[bis(4-hydroxyphenyl)methyl]-2-ethoxyphenol, 4-[bis(4-hydroxyphenyl)methyl]-2-methoxyphenol, 2,4,6-tris(4hydroxyphenylmethyl)-1,3-benzenediol, 4,4'-[1-[4-[1-(4hydroxyphenyl)-1-methylethyl)phenyl]ethylidene]bisphenol, 4-(2,3,5-trimethyl-4-hydroxyphenyl)methyl-1,3-benzenediol and 6,6'-methylenebis[4-(4-hydroxy-3,5dimethylphenylmethyl)-1,2,3-benzenetriol].

The compound having a parameter (P) value of 40 to less than 50 includes e.g. 2,6-bis[(2,4-dihydroxyphenyl) methyl]-4-ethylphenol, 2,4-bis[(2,4-dihydroxyphenyl) methyl]-6-cyclohexylphenol, 2,6-bis[[2,3-dihydroxy-5-(1,1-dimethylethyl) phenyl] methyl]-4-methylphenol, 4,4'-[(3,4-dihydroxyphenyl)methylene]bis[2-(methylethyl)phenol], 2,2'-[(3,4-dihydroxyphenyl) methylene]bis[3,5,6-trimethylphenol], 2,2'-[(3-hydroxy-4-methoxyphenyl)methylene]bis [3,5-dimethylphenol], 2,4',4''-methylidynetrisphenol, 4,4'-[(2-hydroxyphenyl)methylene]bis[3-methylphenol], 4,4',4''-(3-methyl-1-propanyl-3-ylidene)trisphenol, 2,2'-[(3-hydroxyphenyl)methylene]bis[3,5-dimethylphenol], 4,4',4'',4'''-(1,2-ethanediylidene)tetrakisphenol, 4,6-bis[(4-hydroxyphenyl)methyl]-1,3-benzenediol, 4,4'-[(3,4-dihydroxyphenyl) methylene]bis[2-methylphenol], 2,2'-[(2-hydroxyphenyl)methylene]bis[3,5-dimethylphenol], 2,2'-[(4-hydroxyphenyl) methylene]bis[3,5-dimethylphenol], (2,4-dihydroxyphenyl) (4-hydroxyphenyl)methanone, 4-[1-(4-hydroxyphenyl)-1-methylethyl]-1,3-benzenediol, 4-[(3,5-dimethyl-4-hydroxyphenyl)methyl]-1,2,3-benzenetriol, 4,4'-[1,4-phenylenebis (1-methylethylidene)]bis[benzene-1,2-diol], 5,5'-[1,4-phenylenebis(1-methylethylidene)]bis[benzene-1,2,3-triol], 4-(3,4-dihydro-7-hydroxy-2,4,4-trimethyl-2H-1-benzopyran-2-yl)-1,3-benzenediol, 4-[(2,3,5-trimethyl-4-hydroxyphenyl) methyl]-1,2,3-benzenetriol, 4,4'-methylenebis[6-methylcarbonyl-1,3-benzenediol], 6,6'-methylenebis[4-(4-hydroxyphenylmethyl)-1,2,3-benzenetriol], 6,6'-ethylidenebis[4-(4-hydroxyphenylcarboxy)-1,2,3-benzenetriol], 4,4',4''-methylidynetris[2,6-bis[(hydroxyphenyl)methyl]phenol] and 4,4',4''-ethylidenetris[2,6-bis[(hydroxyphenyl)methyl]phenol].

The compound having a parameter (P) value of 50 or more includes e.g. 2,2'-bis[(3,4-dihydroxyphenyl)methylene]bis [3,5-dimethylphenol] and 4-[(4-hydroxyphenyl)methyl]-1,2,3-benzenetriol.

Preferable examples of the additive used in the present invention include:

<u>TPPA</u> (4,4'-[1-[4-[1-(4-hydroxyphenyl)-1-methylethyl] phenyl] ethylidene] bisphenol)

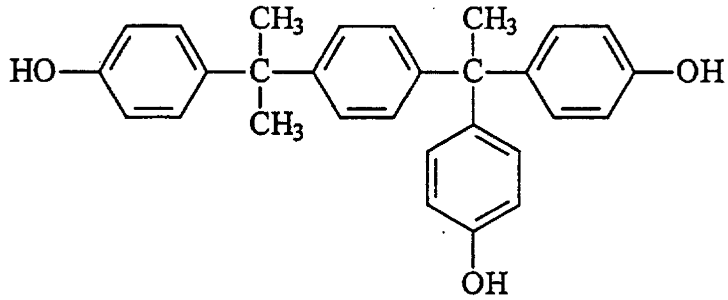

and
BisPG-PD (4,4'-[1,4-phenylenebis(1-methylethylidene)]bis [benzene-1,2,3-triol]).

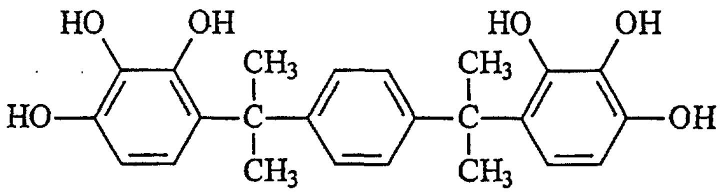

The solvent which can dissolve the radiation sensitive resin composition of the present invention includes ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactates such as methyl lactate and ethyl lactate; aromatic hydrocarbons such as toluene and xylene; ketones such as methyl ethyl ketone, 2-heptanone and cyclohexanone; amides such as N,N-dimethylacetamide and N-methylpyrrolidone; and lactones such as γ-butyrolactone. These solvents can be used alone or in combination of two or more thereof.

Dyestuffs, adhesive aids, surface active agents etc. may be incorporated as necessary into the radiation sensitive resin composition of the present invention. The dyestuffs include e.g. Methyl Violet, Crystal Violet, Malachite Green etc.; the adhesive aids include e.g. alkyl imidazoline, butyric acid, alkyl acid, polyhydroxystyrene, polyvinylmethyl ether, t-butyl novolak, epoxy silane, epoxy polymer, silane etc.; and the surface active agents include e.g. nonionic surface active agents such as polyglycols and derivatives thereof, that is, polypropylene glycol or polyoxyethylene lauryl ether, fluorine-containing surface active agents such as Fluorad (trade name; Sumitomo 3M Ltd.), Megafac (trade name; Dainippon Ink and Chemicals, Inc.), Sulflon (trade name; Asahi Glass Co., Ltd.) or organosiloxane surface active agents such as KP341 (trade name; Shin-Etsu Chemical Co., Ltd.).

Best mode for practicing the Invention

The present invention will now be described more specifically by reference to Examples which, however, are not to be construed to limit the present invention in any way.

Example 1

100 Parts by weight of a novolak resin having a weight average molecular weight of 7,500 as determined using polystyrene standards, 5 parts by weight of an additive of TPPA (Honshu Chemical Industry Co., Ltd.) and 25 parts by weight of a radiation sensitive material of an ester between 2,3,4,4'-tetrahydroxybenzophenone and 1,2-naphthoquinonediazide-4-sulfonyl chloride relative to 100 parts by weight of the total amount of the resin and the additive were dissolved in propylene glycol monomethyl ether acetate. To prevent the so-called striation i.e. radial wrinkles formed on a resist film upon spin coating, the fluorine-based surface active agent Fluorad-472 (Sumitomo 3M Ltd.) was added thereto at 300 ppm, then stirred and filtered through a 0.2 μm filter to prepare the radiation sensitive resin

composition of the present invention. This composition was spin-coated on a 4-inch silicon wafer and baked at 100 °C for 90 seconds on a hot plate to give a resist film of 1.5 μm in thickness. The parameter value of TPPA is 30.75 (see Table 1).

The resist film was exposed through a test pattern having various line and space width patterns, which have 1:1 line and space width respectively, using a stepper (FX-604F, NA = 0.1, g + h line) manufactured by Nikon Corporation, and then developed at 23 °C for 60 seconds with AZ® 300 MIF®, and 2.38 weight % aqueous tetramethyl ammonium hydroxide solution. After development, the sample was observed and measured, assuming that the amount of exposure energy ($E_0$) permitting 5 μm line and space to be resolved into 1 : 1 was sensitivity. The results are shown in Table 2.

Thereafter, the sample was post-baked at 130 °C for 120 seconds on a hot plate and then dry-etched at 100 W and 105 W for 5 and 6 minutes respectively in a gas having a composition of $C_2F_6$ : $CHF_3$ : He = 16 : 24 : 100 in an ion etching unit (RIE-10N) manufactured by Samuco Co., Ltd. After etching, the surface of the coating film was observed, and dry-etching resistance was evaluated under the following criteria. The results are shown in Table 3.

Evaluation criteria

◎ : No change.
○: Uneven like scale.
Δ: Partially cloudy.
×: Completely cloudy.
-: Carbonated.

Example 2

The same procedure as in Example 1 was conducted except that a novolak resin having a weight average molecular weight of 8,000 as determined using polystyrene standards was used as the novolak resin, and that the amount of the additive added was 7.5 parts by weight. The results shown in Tables 2 and 3 were obtained.

Example 3

The same procedure as in Example 1 was conducted except that a novolak resin having a weight average molecular weight of 8,700 as determined using polystyrene standards was used as the novolak resin, and that the amount of the additive added was 10.0 parts by weight. The results shown in Tables 2 and 3 were obtained.

Example 4

The same procedure as in Example 1 was conducted except that a novolak resin having a weight average molecular weight of 7,800 as determined using polystyrene standards was used as the novolak resin, and that BisPG-PD (Honshu Chemical Industry Co., Ltd.) was used in place of TPPA as the additive. The results shown in Tables 2 and 3 were obtained.

The parameter value of BisPG-PD is 44.67 (see Table 1).

Example 5

The same procedure as in Example 4 was conducted except that a novolak resin having a weight average molecular weight of 8,600 as determined using polystyrene standards was used as the novolak resin, and that the amount of the additive added was 7.5 parts by weight. The results shown in Tables 2 and 3 were obtained.

Example 6

The same procedure as in Example 4 was conducted except that a novolak resin having a weight average molecular weight of 9, 600 as determined using polystyrene standards was used as the novolak resin, and that the amount of the additive added was 10.0 parts by weight. The results shown in Tables 2 and 3 were obtained.

Comparative Example 1

The same procedure as in Example 1 was conducted except that a novolak resin having a weight average molecular weight of 5, 300 as determined using polystyrene standards was used as the novolak resin, and that the additive was not added. The results shown in Tables 2 and 3 were obtained.

Comparative Example 2

The same procedure as in Example 1 was conducted except that a novolak resin having a weight average molecular weight of 8,600 as determined using polystyrene standards was used as the novolak resin, and that 7.5 parts of TPPA-1000P shown in the structural formula below was added. The results shown in Tables 2 and 3 were obtained.

The parameter value of TPPA-1000P is 28.50 (see Table 1).

TPPA-1000P

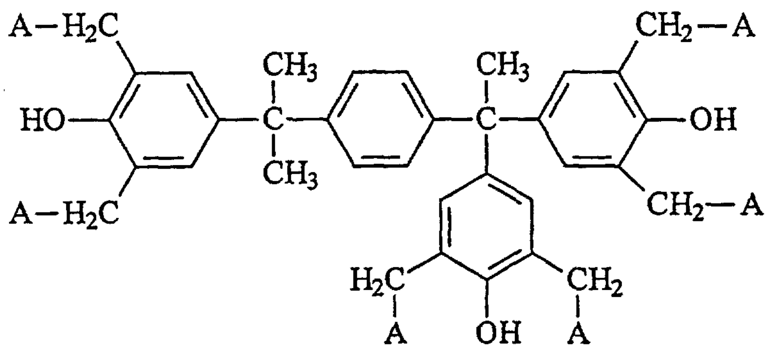

A:

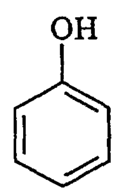

o or p

Table 1

| Additives | Number of benzene ring | Number of OH | Number of reaction point | Parameter (P) |
|---|---|---|---|---|
| TPPA | 4 | 3 | 6 | 30.75 |
| BisPG-PD | 3 | 6 | 4 | 44.67 |
| TPPA-1000P | 10 | 9 | 12 | 28.50 |

Table 2

| | Weight average molecular weight of novolak resin | Additives | Amount of the additive added (parts by weight per 100 parts by weight of the resin) | Sensitivity (Eo) (mJ/ $cm^2$) |
|---|---|---|---|---|
| Example 1 | 7500 | TPPA | 5.0 | 28.0 |
| Example 2 | 8000 | TPPA | 7.5- | 28.0 |
| Example 3 | 8700 | TPPA | 10.0 | 28.0 |
| Example 4 | 7800 | BisPG-PD | 5.0 | 28.0 |
| Example 5 | 8600 | BisPG-PD | 7.5 | 28.0 |
| Example 6 | 9600 | BisPG-PD | 10.0 | 28.0 |
| Comparative Example 1 | 5300 | - | 0. | 28.0 |
| Comparative Example 2 | 8600 | TPPA-1000P | 7.5 | 28.0 |

Table 3

| Etching condition | | Surface conditions of the resist coating film | | | | | | | |
|---|---|---|---|---|---|---|---|---|---|
| W | Time (分) | Example 1 | Example 2 | Example 3 | Example 4 | Example 5 | Example 6 | Comparative Example 1 | Comparative Example 2 |
| 100 | 5 | ○ | ○ | ○ | ○ | ○ | ◎ | △ | × |
| 100 | 6 | × | △ | × | ○ | ○ | ○ | × | – |
| 105 | 5 | × | × | × | △ | △ | ○ | × | – |
| 105 | 6 | – | – | – | – | – | △ | – | – |

As can be seen from Tables 2 and 3, the contradictory characteristics, that is, the effect of improving sensitivity and the effect of improving etching resistance, can be improved with good balance using the compounds having a value of 30 or more in parameter (P) shown in formula 1 as additives. Any resist patterns formed in the Examples were good.

Effect of the Invention

According to the present invention, the radiation sensitive resin composition capable of not only forming excellent patterns but also significantly improving dry-etching resistance while maintaining high sensitivity and high resolution can be obtained. Accordingly, the radiation sensitive resin composition obtained in the present invention is of significant usefulness and can be preferably used for production of semiconductor devices and liquid crystal displays.

## Claims

1. A radiation sensitive resin composition comprising an alkali-soluble resin, a radiation sensitive material, and a compound with phenolic hydroxyl groups which has a value of parameter (P) represented by following formula 1

being 30 or more:

[Formula 1]

parameter (P) = [(13.0 x number of hydroxyl groups in an additive)/(number of benzene rings in an additive)] + [(14.0 x number of diazo-coupling reaction points in an additive) / (number of benzene rings in an additive)]

wherein the number of diazo-coupling reaction points is the number of unsubstituted carbon atoms at o- and p-positions relative to the positions of hydroxyl groups in the benzene ring in the compound.

**2.** A radiation sensitive resin composition according to claim 1, wherein said compound with phenolic hydroxyl groups is one with phenolic hydroxyl groups represented by the following general formulae (I) to (V) and having a value of parameter (P) represented by formula 1 being 30 or more:

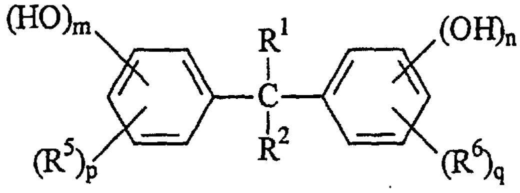

(I)

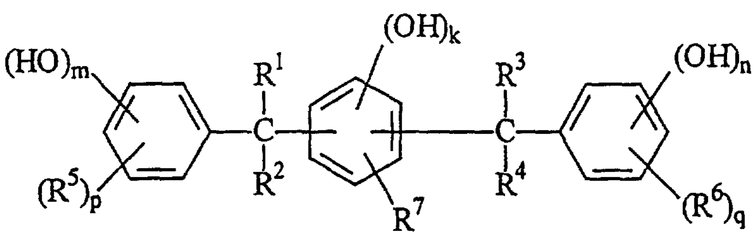

(II)

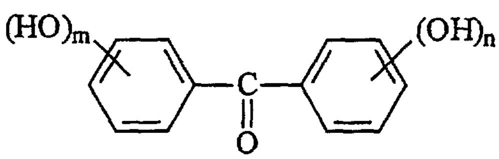

(III)

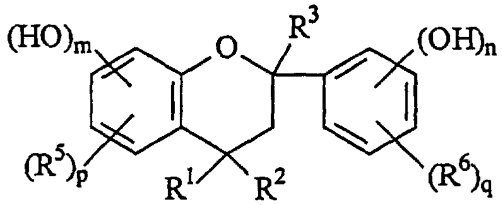

(IV)

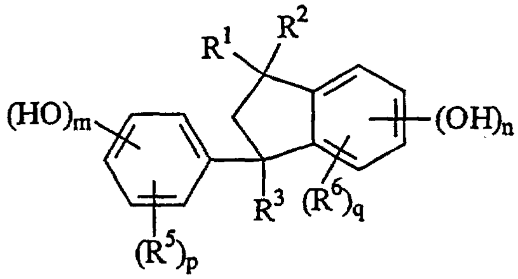

(V)

wherein $R^1$, $R^2$, $R^3$ and $R^4$ are independent to each other, may be the same, and represent a hydrogen atom, a $C_1$ to $C_{10}$ alkyl group, a hydroxyphenyl group, a polyvalent hydroxyphenyl group, a hydroxyphenethyl group, a hydroxybenzyl group, a poly(hydroxyphenyl)methyl group or a bis(hydroxybenzyl)-hydroxyphenyl group, $R^5$ and $R^6$ are independent to each other, may be the same, and represent a hydrogen atom, a $C_1$ to $C_{10}$ alkyl group, an acetyl group, a hydroxybenzyl group, a hydroxybenzoyl group or a hydroxymesityl group, and $R^7$ represents a hydrogen atom, a $C_1$ to $C_{10}$ alkyl group, a $C_3$ to $C_{10}$ cycloalkyl group or a hydroxybenzyl group, whereupon in the substituents described above, the benzene ring may be substituted with other substituents such as a $C_1$ to $C_{10}$ alkyl group and a $C_1$ to $C_{10}$ alkoxyl group, and k, m, n, p and q represent 0 or an integer of 1 to 5.

**3.** A radiation sensitive resin composition according to claim 2, wherein said compound with phenolic hydroxyl groups is 4,4'-[1-[4-[1-(4-hydroxyphenyl)-1-methylethyl]phenyl]-ethylidene]bisphenol or 4,4'-[1,4-phenylenebis(1-methyl-ethylidene)]bis[benzene-1,2,3-triol].

**4.** A method for improving the dry-etching resistance of a radiation sensitive resin composition by inclusion of an alkali-soluble resin, a radiation sensitive material, and a compound with phenolic hydroxyl groups which has a value of parameter (P) represented by formula 1 in claim 1 being 30 or more.

**5.** A method for improving the dry-etching resistance of a radiation sensitive resin composition according to claim 4, wherein said compound with phenolic hydroxyl groups is one with phenolic hydroxyl groups represented by the general formulae (I) to (V) in claim 2 and having a value of parameter (P) represented by formula 1 being 30 or more.

**6.** A method for improving the dry-etching resistance of a radiation sensitive resin composition according to claim 5, wherein said compound with phenolic hydroxyl groups is 4,4'-[1-[4-[1-(4-hydroxyphenyl)-1-methylethyl]phenyl]-ethylidene]bisphenol or 4,4'-[1,4-phenylene bis(1-methyl-ethylidene)]bis[benzene-1,2,3-triol].

## INTERNATIONAL SEARCH REPORT

International application No.
PCT/JP00/03925

**A. CLASSIFICATION OF SUBJECT MATTER**

Int.Cl[7] G03F 7/022, C08L 101/00, H01L 21/027

According to International Patent Classification (IPC) or to both national classification and IPC

**B. FIELDS SEARCHED**

Minimum documentation searched (classification system followed by classification symbols)

Int.Cl[7] G03F 7/00-7/42

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2000 |
| Kokai Jitsuyo Shinan Koho | 1971-2000 | Jitsuyo Shinan Toroku Koho | 1996-2000 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP, 4-251849, A (Fuji Photo Film Co., Ltd.), 08 September, 1992 (08.09.92), Par. Nos.[0034], [0005]-[0007], (Family: none) | 1-6 |
| X | JP, 4-211254, A (Japan Synthetic Rubber Co., Ltd.), 03 August, 1992 (03.08.92), Par. Nos.[0022],[0003], & EP, 443820, A & US, 5238775, A & DE, 69130130, E | 1-6 |
| X | JP, 4-36751, A (Tokyo Ohka Kogyo Co., Ltd.), 06 February, 1992 (06.02.92), Claim 2; page 2, upper right column, lines 11-19 (Family: none) | 1-6 |
| X<br>Y | JP, 3-200252, A (Nippon Zeon Co., Ltd,), 02 September, 1991 (02.09.91), page 8, upper left column (33), & EP, 435437, A & US, 5112719, A & DE, 69019706, E | 1-3<br>4-6 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 August, 2000 (30.08.00) | 12 September, 2000 (12.09.00) |

| Name and mailing address of the ISA/ | Authorized officer |
|---|---|
| Japanese Patent Office | |
| Facsimile No. | Telephone No. |

Form PCT/ISA/210 (second sheet) (July 1992)

## INTERNATIONAL SEARCH REPORT

International application No.
PCT/JP00/03925

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP, 200253, A (Nippon Zeon Co., Ltd.),<br>02 September, 1991 (02.09.91),<br>page 4, lower left column (16), (Family: none) | 1-3<br>4-6 |
| X<br>Y | JP, 4-299348, A (Japan Synthetic Rubber Co., Ltd.),<br>22 October, 1992 (22.10.92),<br>Par. Nos.[0011],[0003], (Family: none) | 1,2,4,5<br>3,6 |
| X<br>Y | JP, 3-259149, A (Fuji Photo Film Co., Ltd.),<br>19 November, 1991 (19.11.91),<br>page 4; page 2, lower left column, line 12 to page 3,<br>upper left column, line 7<br>& EP, 445819, A | 1,2,4,5,<br>3,6, |
| X<br>Y | JP, 2-2560, A (Sumitomo Chemical Company, Limited),<br>08 January, 1990 (08.01.90),<br>page 4, upper left column, (Family: none) | 1,2<br>3-6 |
| X<br>Y | JP, 5-72728, A (Toray Industries, Inc.),<br>26 March, 1993 (26.03.93),<br>Par. Nos.[0068],[0076], (Family: none) | 1-3<br>4-6 |
| X<br>Y | JP, 7-159990, A (Nippon Zeon Co., Ltd.),<br>23 June, 1995 (23.06.95)<br>Par. Nos.[0130],[0125], (Family: none) | 1-3<br>4-6 |
| X | JP, 10-133368, A (Tokyo Ohka Kogyo Co., Ltd.),<br>22 May, 1998 (22.05.98),<br>Par. Nos.[0031]-[0037], [0002]-[0013],<br>& US, 5853948, A | 1-6 |

Form PCT/ISA/210 (continuation of second sheet) (July 1992)